# FASCICULE DE BREVET EUROPEEN

(11) **EP 0 588 675 B1**
(45) Date de publication et mention de la délivrance du brevet: **29.06.2005**
(21) Numéro de dépôt: 93402042.1
(22) Date de dépôt: 11.08.1993
(51) Int. Cl.: H01L 33/00, G02B 6/42

(54) **Procédé d'hybridation et de positionnement d'un composant optoélectronique par rapport à un guide optique intégré**
Verfahren zur Hybridisierung und Positionierung eines optoelektrischen Bauelements hinsichtlich eines integrierten Lichtwellenleiters
Method of hybridization and positioning of an optoelectronic component in relation to an integral optical waveguide

(30) Priorité: 14.08.1992 FR 9210040
(43) Date de publication de la demande: 23.03.1994
(73) Titulaire: COMMISSARIAT A L'ENERGIE ATOMIQUE, 75015 Paris Cédex 15 (FR)
(72) Inventeur: Valette, Serge, F-38100 Grenoble (FR); Ravetto, Michel, F-38240 Meylan (FR); Destefanis, Gérard, F-38120 Saint Egreve (FR)
(74) Mandataire: Poulin, Gérard

(56) Documents cités:
- FR-A- 2 424 685
- US-A- 5 023 881
- JOURNAL OF LIGHTWAVE TECHNOLOGY vol. 10, no. 3 , Mars 1992 , NEW YORK, USA pages 336 - 340 E.E.L. FRIEDRICH ET AL. 'Hybrid integration of semiconductor lasers with Si-based single-mode ridge waveguides'
- PATENT ABSTRACTS OF JAPAN vol. 10, no. 41 (P-429)(2098) 18 Février 1986 & JP-A-60 188 913 (MATSUSHITA DENKI SANGYO K.K.) 26 Septembre 1985
- IEEE TRANSACTIONS ON COMPONENTS,HYBRIDS,AND MANUFACTURING TECHNOLOGY vol. 13, no. 4 , Décembre 1990 , NEW YORK US pages 780 - 786 M.J. WALE ET AL. 'Self-aligned Flip-Chip assembly of photonic devices with electrical and optical connections'
- FREQUENZ vol. 45, no. 9-10 , Septembre 1991 , BERLIN DE pages 245 - 252 J. MÜLLER ET AL. 'Trench bulge waveguides for integrated optical circuits'
- SENSORS AND ACTUATORS A vol. A23, no. 1-3 , Mars 1990 , LAUSANNE CH pages 1087 - 1091 S. VALETTE ET AL. 'Silicon based integrated optics technology for optical sensor applications'

## Description

La présente invention a pour objet un procédé d'hybridation et de positionnement d'un composant optoélectronique intégré sur un substrat et plus spécialement un procédé d'hybridation d'un composant optoélectronique à guidage de lumière confiné tel qu'une diode laser et de positionnement de ce composant par rapport à un guide de lumière, notamment à confinement latéral, intégrés sur un même substrat.

Elle trouve une application dans le domaine de l'optique intégrée notamment pour le traitement de signaux en temps réel, les capteurs et les mémoires optiques, et dans le domaine des télécommunications par voie optique.

Le montage d'une diode laser sur un substrat et son positionnement par rapport à un guide de lumière est un problème fondamental en optoélectronique intégrée pour les raisons suivantes :
- la précision d'alignement de la diode et du guide de lumière requise doit être inférieure à 0,5 micromètre, avec un rendement de couplage optique le plus élevé possible,
- les lasers à semiconducteur sont sensibles aux défauts de dissipation thermique des montages mis en oeuvre,
- les diodes lasers ont un comportement sensible au phénomène de retour de lumière dans la cavité laser par réflexion non désirée de lumière, dès qu'elles sont couplées avec un circuit optique extérieur (phénomène dit d'"optical feedback" en terminologie anglo-saxonne), entraînant leur instabilité.

Les problèmes rencontrés pour l'alignement et le montage d'un composant laser sur un substrat sont illustrés, par exemple, par le document US-A-5 023 881.

L'hybridation d'un laser avec un guide optique est également illustré par le document "Hybrid integration of semiconductor lasers with Si-based single-mode ridge waveguide" de E. Friedrich et al., Journal of Lightwave Technology, vol. 10, n° 3, mars 1992, pp. 336-340.

Le but de l'invention est de proposer en particulier une solution au problème d'alignement et de montage notamment dans le cas d'une diode laser et d'un guide optique réalisés en technologies optiques intégrées sur silicium.

Etant donné que ce problème d'intégration sur un substrat et de position par rapport à un guide optique n'est pas lié aux simples diodes lasers mais à tous composants optoélectroniques, l'invention a pour objet, de façon générale, un procédé d'hybridation et de positionnement d'un composant optoélectronique par rapport à un guide optique à lumière confinée.

Ce composant optoélectronique peut être un circuit optique intégré ou un détecteur de rayonnement, ces circuits et détecteurs étant réalisés par exemple en technologie III-V ou II-VI ou IV-IV.

Le procédé d'hybridation et de positionnement de l'invention utilise la soudure par galette métallique du composant sur un substrat. La soudure d'un composant électrique sur un substrat par galette métallique (ou technique "flip-chip" en terminologie anglo-saxonne) est en particulier décrite dans le document FR-A-2 646 558.

La technique connue de soudure par galette métallique ne permet pas une précision sur le positionnement d'un composant meilleur que 1 à 3 micromètres. En effet, dans ces techniques connues la précision de l'alignement est déterminée par les dimensions de la galette de soudure. Cette précision est tout à fait insuffisante pour le montage d'une diode laser ou d'un composant à guidage de lumière plan ou confiné par rapport à un guide optique.

L'invention, telle que définie par la revendication 1 et les revendications dépendantes, a pour objet un procédé d'hybridation et de positionnement d'un composant optoélectronique assurant un positionnement à une précision inférieure à 0,5 micromètre.

De façon plus précise l'invention a pour objet un procédé d'hybridation et de positionnement latéral et vertical, sur un substrat, d'un composant optoélectronique intégré à guidage confiné de la lumière par rapport à une extrémité d'un guide optique formé sur ce substrat et comportant un coeur guidant, le composant comportant au moins un plot en un premier matériau sur une face à hybrider, ce procédé consistant à :
- former sur le substrat au moins une butée dont la partie supérieure détermine le positionnement latéral de ce composant par emboîtement dans au moins une encoche spéciale, formée sur la face du composant à hybrider de façon à être autoalignée avec une zone active du composant
- former des cales d'épaisseur sur le substrat, destinée à supporter le composant lorsque qu'il est soudé au substrat, ayant une hauteur fixant le positionnement vertical du compostant, la butée étant intercalée entre les cales d'épaisseur,
- former au moins un plot d'un second matériau sur le substrat, décalé par rapport à la cale d'épaisseur,
- former sur le plot de second ou de premier matériau une galette de soudure en un matériau fusible, apte à mouiller à l'état fondu les premier et second matériaux et pas leur environnement,
- positionner le composant de façon que la butée s'emboîte dans l'encoche et que la galette de soudure soit en regard du plot non pourvu de galette,
- porter l'ensemble à une température assurant la fusion de la galette, et
- ramener l'ensemble à une température inférieure à la température de fusion du matériau de la galette; les cales d'épaisseur présentant une hauteur inféreure à une épaisseur séparant le composant du substrat avant la fusion de la galette.

Le substrat utilisé peut être du verre, du niobate de lithium ou du silicium. On utilise de préférence du silicium qui assure, par sa grande conductivité thermique, la dissipation de la chaleur dégagée par le composant optoélectronique, dissipation thermique nécessaire au bon fonctionnement de ce composant. De plus, la technologie optique intégrée sur silicium, basée sur des dépôts de multicouches, est bien adaptée à la définition d'un procédé d'auto-alignement.

Les plots formés sur le composant électronique et sur le substrat sont généralement métalliques. Aussi, pour assurer une bonne isolation électrique de ce composant, notamment lorsque d'autres composants optoélectroniques doivent être hybridés sur le même substrat, une couche mince d'isolant électrique peut être prévue entre le substrat et les plots en second matériau, supportés par le substrat. Cette couche peut être en silice, en nitrure de silicium, ou en oxynitrure de silicium.

Le matériau de soudure doit présenter un bas point de fusion comme l'étain, l'indium, le plomb et les alliages métalliques à base d'étain, d'indium ou de plomb, et les eutectiques à base de silicium tel Si-Au, Si-Sn, etc. Ils doivent assurer une excellente mouillabilité sur les plots.

Les premier et second matériaux sont notamment réalisés en métal tel que l'or, le platine, le palladium, etc.

De façon avantageuse le second matériau a une surface supérieure à celle de la galette et à celle du plot de premier matériau afin de jouer le rôle de radiateur et d'augmenter la surface d'échange avec le substrat d'hybridation, lorsque celui-ci est un bon dissipateur de chaleur (cas par exemple du silicium).

Lorsque le composant à hybrider est fait sur un substrat à conductivité thermique supérieure à celle du substrat sur lequel a lieu l'hybridation, la surface du premier matériau sera alors choisie supérieure à celle de la galette et du second matériau.

Le procédé d'hybridation de l'invention peut également utiliser les forces de tension superficielles au moment de la soudure pour effectuer le positionnement latéral du composant optoélectronique. En effet, au moment de la fusion du matériau de soudure, le plot du composant et celui du substrat s'auto-alignent avec la galette de soudure.

Cet effet facilite la mise en place des butées latérales pour un auto-alignement avec le coeur du guide, par rapport aux encoches correspondantes réalisées de façon similaire sur le composant à hybrider.

Les cales d'épaisseur permettent un positionnement vertical précis du composant optoélectronique meilleur que celui obtenu en utilisant uniquement l'épaisseur de la galette de soudure comme dans l'art antérieur cité précédemment.

Afin d'améliorer le positionnement latéral du composant optoélectronique, il est avantageux de former sur le substrat, de part et d'autre de la galette, des butées destinées au positionnement latéral du composant. Pour atteindre les précisions de positionnement requises ces butées doivent être "auto-alignées" avec le coeur du microguide de lumière.

Cela signifie que, pour éviter les incertitudes de positionnement dues à la mise en oeuvre de masques différents pour réaliser la partie supérieure des butées, partie qui sert à cet alignement latéral, et le coeur du microguide, on utilise un seul masque et une même étape de gravure pour définir ces deux éléments.

Ce point est d'autant plus fondamental que les topographies des circuits optiques intégrés sont très tourmentées (creux et bosses de plusieurs µm) et rendent très difficile la superposition de jeux de masques différents à mieux que 1,5 ou 2µm.

Avec un seul masque, les différents éléments situés sur le masque peuvent être alignés à 0,1µm près (en particulier parce que l'assemblage des différentes parties du masque s'effectue à échelle 10).

Dans ce cas, on réalise dans le composant à hybrider des encoches destinées à venir s'emboîter sur ces butées, encoches elles aussi "auto-alignées" avec la zone de guidage du composant, zone qui constitue par exemple la partie active de la diode laser.

Conformément à l'invention, il est possible d'utiliser une ou plusieurs galettes de soudure associées à un ou plusieurs plots de premier et second matériaux. En particulier, les plots de premier matériau correspondent aux électrodes du composant.

De façon avantageuse, on utilise des galettes dont la forme est une réplique des plots ou électrodes de premier matériau du composant optoélectronique.

En particulier, la galette présente la forme d'une bande dont la longueur est adaptée à celle du composant. Ceci est particulièrement vrai dans le cas de diodes lasers ou de modulateurs en matériaux III-V.

Il est clair qu'il peut y avoir plusieurs bandes parallèles notamment dans le cas des modulateurs en LiNbO₃ qui comportent en général 2 ou 3 électrodes.

Par ailleurs, afin d'assurer une bonne stabilité du composant optoélectronique, on forme plusieurs cales d'épaisseur réparties régulièrement sur le substrat de façon à pouvoir supporter le composant par sa périphérie.

L'invention s'applique plus spécialement à l'hybridation et au positionnement sur un substrat d'un composant optoélectronique à guidage planaire et surtout confiné de la lumière tel qu'une diode laser par rapport à l'extrémité d'un guide optique formé sur un substrat.

De façon connue, un guide optique comporte un coeur (ou ruban guidant) intercalé entre une couche supérieure et une couche inférieure de matériaux d'indice de réfraction inférieur à celui du coeur.

La couche supérieure peut être de l'air.

Dans cette application particulière, les cales d'épaisseur sont définies dans au moins la couche supérieure du guide optique par gravure de cette couche, de part et d'autre du ruban. En outre, le plot de second matériau est formé sur le substrat dans le prolongement du guide et en regard de ladite extrémité.

De plus, les butées utilisées pour le positionnement latéral de la diode sont définies par gravure d'au moins la couche supérieure du guide de part et d'autre du coeur.

Selon l'invention les parties supérieures des butées qui constituent la zone de positionnement effective sont alors réalisées avantageusement en même temps que le guide optique, c'est-à-dire comme on l'a dit précédemment, à partir d'un même étage de gravure utilisant un même masque.

En technologie optique intégrée sur silicium, le guide optique est formé dans une structure guide de type OIS utilisant des couches de silice.

En particulier les structures guides utilisées sont du type Si/SiO₂/Si₃N₄/SiO₂, noté OIS₁ ou du type Si/SiO₂/SiO₂ haut indice/SiO₂, noté OIS₂.

Les couches de silice de la structure OIS₁ et OIS₂ peuvent être dopées par un matériau diminuant leur indice de réfraction comme le bore ou le fluor ou être dopées par un matériau augmentant leur indice de réfraction comme le phosphore, le germanium, le titane ou l'azote.

Bien entendu, pour obtenir une structure guide, le matériau du ruban doit présenter un indice de réfraction supérieur à celui des couches de confinement.

Il est en outre possible de remplacer le nitrure de silicium par de l'alumine ou de l'oxynitrure de silicium SiOₓN_{y} avec O≤x≤2, O≤y≤4/3 et 0≤x+y≤2.

Il est éventuellement possible de remplacer le substrat de silicium par un substrat en silice ou en verre bien que ceux-ci possèdent une conductivité thermique plus faible.

Le procédé décrit peut également être mis en oeuvre avec d'autres types de guides de lumière dans la mesure où ceux-ci sont formés de plusieurs couches superposées obtenues par dépôt divers ou par épitaxie.

De façon avantageuse, on utilise une lentille de focalisation en bout de guide pour faciliter le positionnement du composant par rapport à l'extrémité du guide optique tout en assurant un bon couplage entre le composant et le guide.

Par exemple, pour une structure OIS₁, le positionnement d'une diode par rapport au guide, en l'absence de la lentille, doit être fait à 0,1µm près en hauteur et entre 0,5 et 1µm en largeur, alors que le couplage (ou quantité de lumière reçu par le guide) entre la diode et le guide est de 90% environ. Cette contrainte de positionnement est due à la fine épaisseur du ruban du guide. Grâce à l'emploi de la lentille, le positionnement en hauteur peut être fait entre 0,5 et 1µm près avec un couplage >90%.

Pour une structure OIS₂, le couplage entre une diode et un guide optique n'est que de 10 à 15% avec un positionnement de 0,5 à 1µm près en hauteur. Ce faible couplage résulte des faibles différences d'indice entre le ruban et les couches de confinement et la divergence de la diode.

Pour augmenter ce couplage, il faudrait placer la diode au contact du guide, ce qui risque d'endommager la diode du fait de sa fragilité et d'augmenter les réflexions de lumière sur le guide qui pénètrent à nouveau dans la diode perturbant ainsi son fonctionnement. Une solution à ce problème serait l'emploi d'un isolateur mais son emploi est incompatible avec la technique d'hybridation.

Ce problème est résolu dans l'invention avec la lentille de focalisation. Ainsi, le couplage augmente jusqu'à 70% et la diode peut être placée à une distance de l'ordre de 2 fois la distance focale de la lentille, limitant ainsi les réflexions parasites sur le guide et les risques de détérioration de la diode.

D'autres caractéristiques et avantages de l'invention ressortiront mieux de la description qui va suivre, donnée à titre illustratif et non limitatif, en référence aux figures annexées, dans lesquelles :
- la figure 1 représente schématiquement en coupe longitudinale une diode laser et un guide de lumière avec une lentille en bout, intégrés sur un même substrat et positionnés l'un par rapport à l'autre,
- la figure 2 est une vue de dessus du montage de la figure 1,
- la figure 3 est une variante du montage diode-guide de la figure 1,
- les figures 4 à 9 représentent schématiquement des différentes étapes d'"auto-alignement" et d'hybridation de la diode de la figure 1 par rapport au guide de lumière : les figures 4, 7 et 9 sont des vues en coupe transversale, la figure 5 montre en vue de dessus les différents masques de gravure utilisés, les figures 6 et 8 sont des vues en perspective.

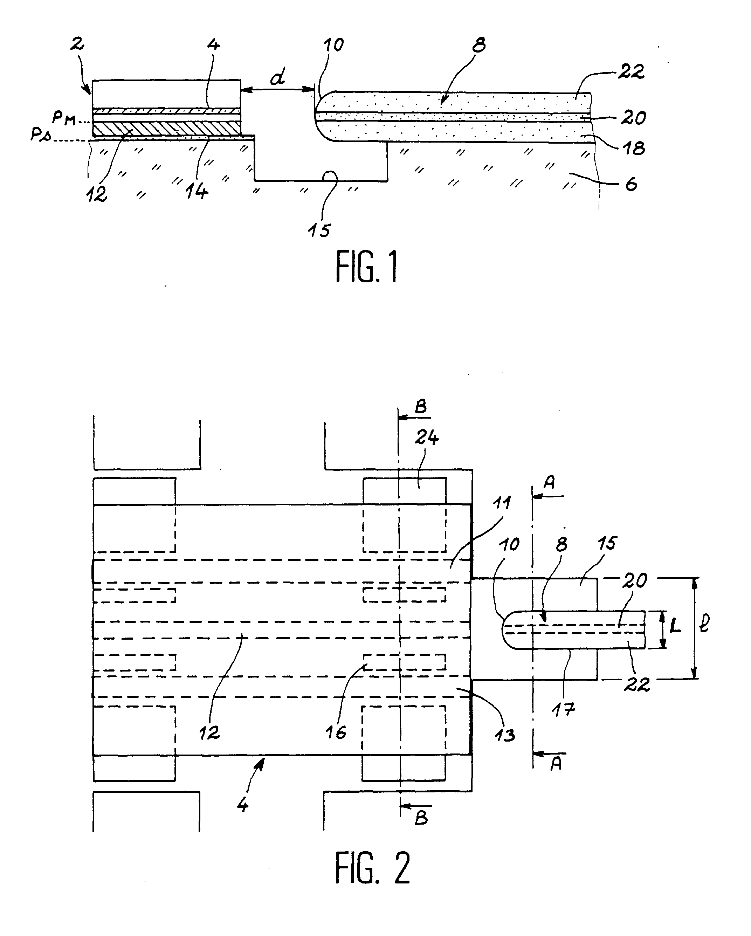

On décrit ci-après l'hybridation d'une diode laser 2, comme représenté sur les figures 1 et 2, équipée d'une zone active 4 en général confinée, sur un substrat en silicium 6 et son positionnement par rapport à l'extrémité d'un guide de lumière 8 à confinement latéral, pourvue d'une lentille de focalisation 10.

Un guide de lumière à confinement latéral est sous-appelé microguide par opposition à un guide planaire.

La diode 2 peut être réalisée en matériau III-V comme décrit dans le document "Evolution et perspectives des structures lasers pour télécommunications" de J.C. Bouley, Echo des Recherches n°130, 4ème trimestre 1987, pages 59 à 68 ou dans le document "Long wavelength conductor lasers" de G.P. Agraval et N.K. Dutto, Editions Van Nostrand Reinhold Cie, New York 1986.

Selon l'invention, elle est fixée par une soudure métallique 12 par exemple, à base d'un eutectique, d'indium, de plomb et d'étain ou de mélange de ces matériaux.

Afin d'isoler électriquement la diode 2 du substrat 6, une couche d'isolement électrique 14 peut éventuellement être intercalée entre le substrat 6 et la diode.

Dans une structure OIS, cet isolant 14 peut être favorablement de la silice de 10 à 500 nm d'épaisseur. Toutefois, on peut utiliser du Si₃N₄ ou un polyimide.

Comme représenté sur les figures 1 et 2, la lentille 10 est formée au-dessus d'un évidement 15 pratiqué dans le substrat. La lentille a une forme quasi hémisphérique et a un diamètre de 5 à 50µm et l'évidement a une largeur 1 de 15 à 200µm et une profondeur supérieure à la largeur du guide.

En outre, la distance d séparant la lentille de la diode est de l'ordre de 2 fois la distance focale de la lentille.

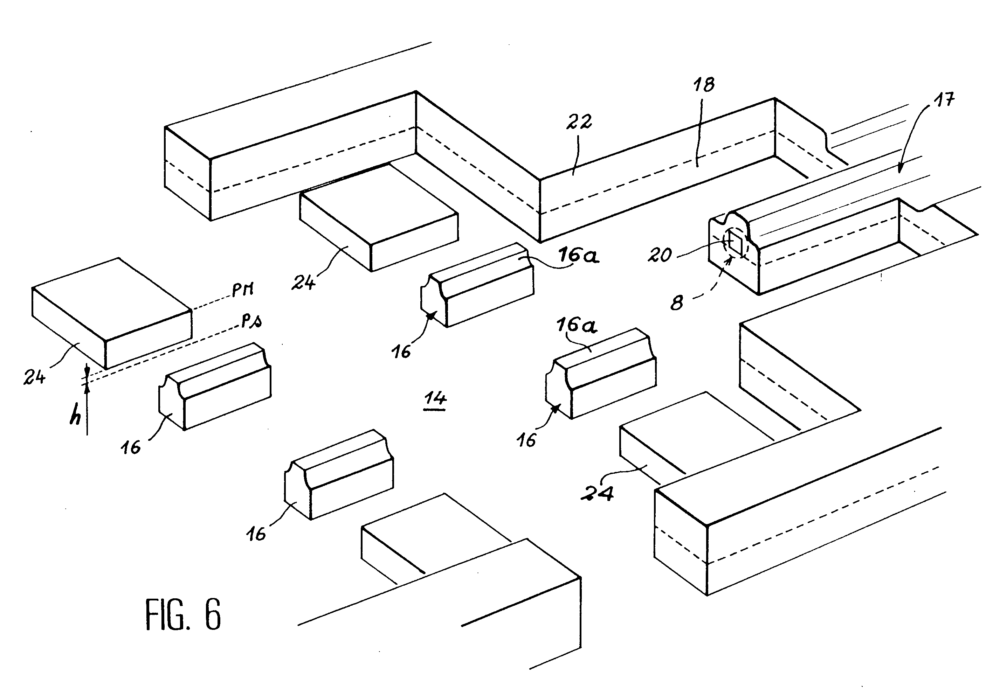

Afin d'éviter la perte d'information lumineuse dans le guide 8, la lentille est formée en bout d'une languette 17 de dimensions transversales L au moins égales à celles du volume occupé par la lumière guidée (voir figure 6). Cette languette a une longueur par exemple de 20 à 200µm.

La forme hémisphérique en bout de la languette est obtenue par fusion locale de celle-ci par exemple par focalisation sur cette zone d'un laser CO₂.

Sur la figure 2, on a représenté des butées 16 assurant un positionnement latéral de la diode par rapport à la lentille 10 d'extrémité du guide d'onde 8.

Ces butées 16 sont, dans la structure OIS, favorablement en silice. On peut aussi utiliser un polyimide. Elles sont auto-positionnées par rapport au microguide 8.

Dans la structure OIS₂, le guide 8 comporte une couche tampon 18 en silice, une couche guide 20 en silice à haut indice de réfraction et une couche 22 de confinement supérieur en silice. La silice peut être dopée ou non avec des dopants diminuant ou augmentant son indice de réfraction de façon que la couche 20 présente un indice de réfraction supérieur à celui des couches de confinement 18 et 22.

Typiquement, les couches 18 et 22 sont en silice non intentionnellement dopées de 4 à 15 µm d'épaisseur et la couche 20 est en silice dopée avec des ions augmentant son indice de 0,5 à 8 µm d'épaisseur.

Comme représenté sur la figure 2, le soudage de la diode 2 peut être assuré uniquement à l'aide d'une soudure centrale 12 ou bien à l'aide de cette soudure 12 et de deux soudures latérales 11 et 13 assurant en outre une stabilisation de la diode lors de son hybridation.

De plus, la diode 2 repose par sa périphérie sur des cales d'épaisseur 24, réalisées favorablement en silice dans la structure OIS. On peut cependant utiliser un polyimide, du Si₃N₄ ou de l'Al₂O₃.

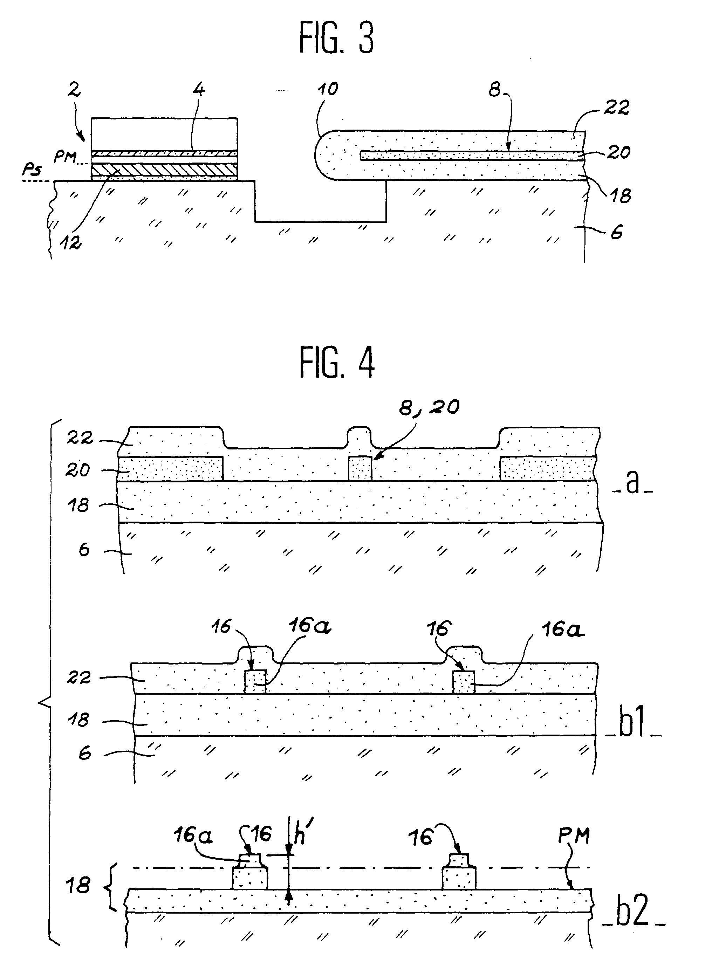

Le montage de la figure 3 se différencie de celui des figures 1 et 2 par la nature de la structure guide. Dans ce cas, le coeur 20 du guide est réalisé en un matériau à haut indice de réfraction comme Al₂O₃, Si₃N₄ ou SiOₓN_{y}. Dans ce cas, les couches de silice 18 et 22 ont respectivement une épaisseur de 2 à 10 µm et de 1 à 5 µm et la couche coeur 20 à une épaisseur de 50 à 1000 nm.

La première étape de réalisation du montage des figures 1 et 2 consiste, comme représenté sur la figure 4, à déposer les couches 18 et 20 en silice et silice haut indice, sur le substrat 6 selon la technique de dépôt chimique en phase vapeur (CVD) assisté ou non par un plasma (PECVD). Les parties a et b₁ de cette figure sont des coupes transversales selon la ligne A-A et B-B de la figure 2 et la partie b₂ de cette figure une coupe aussi selon la ligne B-B de la figure 2.

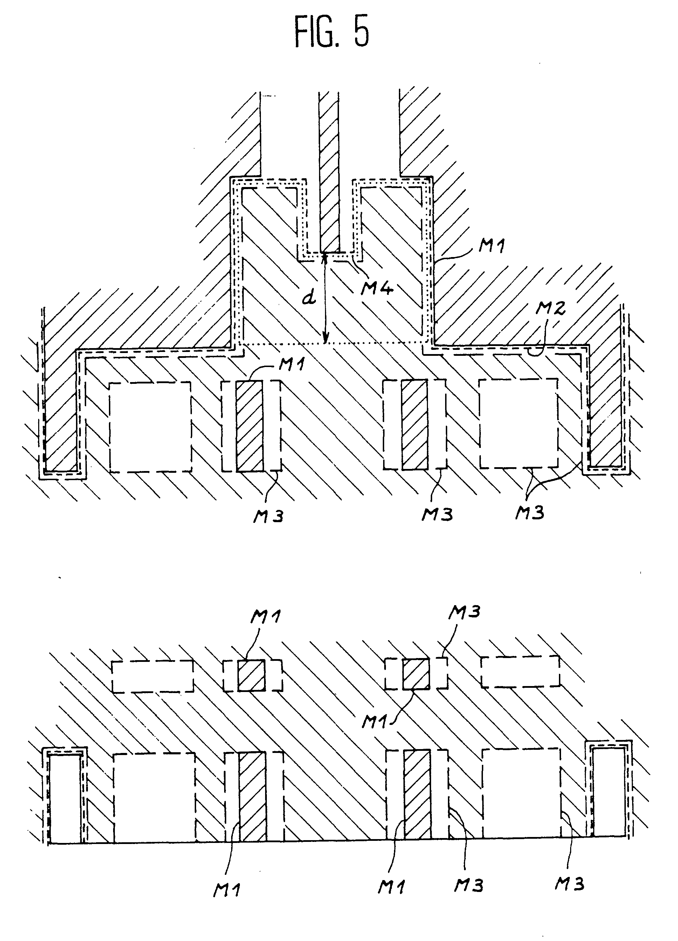

On effectue ensuite une gravure de la couche 20 pour former le coeur du guide 8 ainsi que la partie supérieure 16a des butées 16. Cette gravure est réalisée par voie sèche en utilisant avantageusement le même masque M1 représenté en trait plein sur la figure 5.

Cette étape est l'étape clef du procédé d'"auto-alignement" latéral du coeur du guide et des butées et par conséquent du positionnement parfait de ce coeur avec la zone active du composant.

On effectue alors le dépôt de la couche 22 de confinement supérieur sur la structure obtenue, comme représenté sur la figure 4 par CVD ou PECVD.

A l'aide du masque M2 représenté en traits courts sur la figure 5, on grave la structure guide de façon à définir le plan PM ou niveau de référence sur lequel reposera la diode laser au stade final de son hybridation ainsi que la forme de la languette 17 et des butées 16.

Dans le cas représenté sur les figures, ce plan PM est défini par gravure de la couche de silice 22, éventuellement de la couche 20 sur toute leur épaisseur et éventuellement d'une partie de la couche 18 (comme c'est le cas sur la partie b₂ de la figure 4 et la figure 6) Cette gravure définit donc la surface supérieure des cales d'épaisseur 24 comme représenté sur la figure 6, définissant le positionnement en hauteur de la diode.

La profondeur de cette gravure est déterminée par les hauteurs respectives des coeurs du guide et de la diode à hybrider par rapport au plan de référence des deux composants respectifs.

Après les deux gravures selon les masques M1, M2, les butées sont achevées et leur hauteur h' est de l'ordre de l'épaisseur du microguide optique.

On effectue alors une gravure de la structure à l'aide du masque M3 représenté en traits pointillés longs sur la figure 5, fixant l'emplacement et les dimensions des cales d'épaisseur 24, celles des parties inférieures des butées 16 ainsi que les dimensions de l'extrémité du guide optique 8 qui supportera la lentille 10. Après cette gravure, la structure est celle de la figure 6.

Cette gravure peut directement atteindre le substrat si celui-ci est isolant ou s'il n'y a pas nécessité d'isoler électriquement les différentes connexions (cas rarissime).

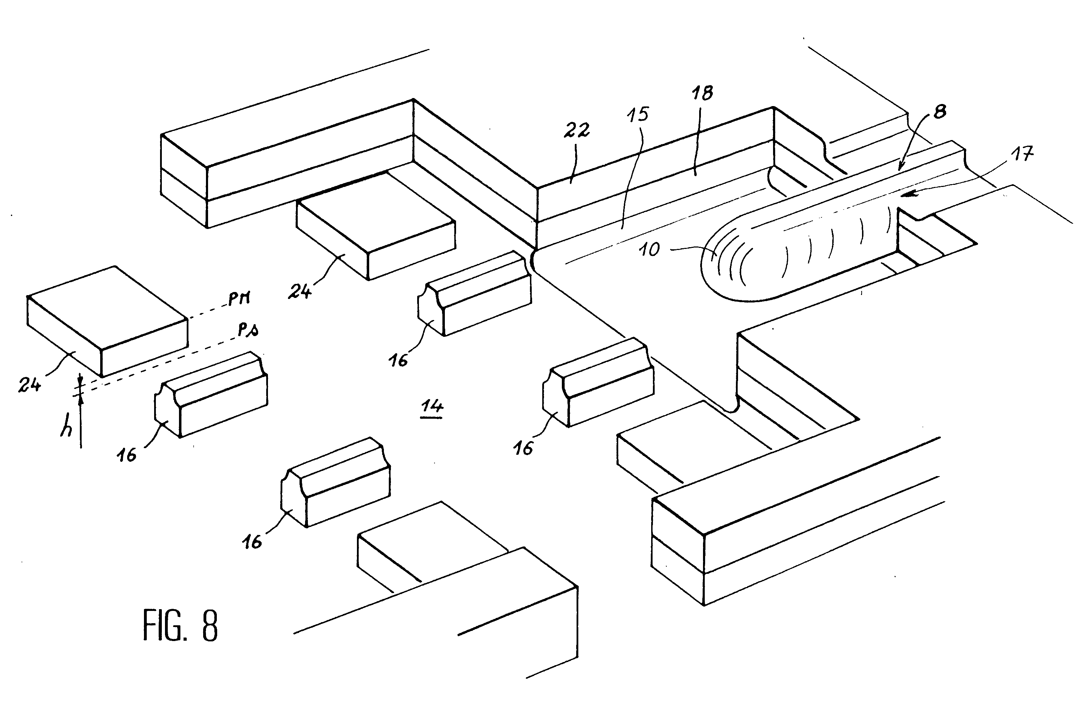

Le plus souvent, cette gravure est arrêtée au-dessus du substrat afin de maintenir une faible couche d'isolant 14 d'épaisseur h (figure 7). Cette couche sera le plus souvent en silice.

Ces deux dernières étapes utilisent les masques M2 et M3 qui peuvent être inversés en modifiant légèrement les masques M2 et M3. Avec le masque M3, on grave par exemple la structure complète en laissant une épaisseur h d'isolant 14 avant d'atteindre le substrat et en protégeant les futures cales 24 et butées 16. Puis avec le masque M2 on définit le plan de référence PM.

Les figures 6 et 8 correspondent à la première procédure (M2 avant M3).

L'étape suivante du procédé est représentée sur la figure 7 qui est une vue en coupe transversale selon la direction B-B de la figure 6.

On dépose successivement deux couches de métal 26 et 28 sur l'ensemble de la structure de respectivement de 0,2 à 2µm et de 3 à 50µm d'épaisseur par exemple. La surface de la couche 28 définit le plan PG situé à un niveau supérieur au plan PM par rapport au plan du substrat PS.

La différence D séparant le plan PG du plan PM est au moins égale à l'incertitude de réalisation de ces deux plans. On choisit donc D de façon que compte tenu de cette incertitude, PG soit toujours au-dessus du plan PM. En pratique D est choisi entre 0,5 et 5 micromètres.

On effectue alors une gravure des couches 26 et 28 de façon à définir les galettes de soudure 28 et les zones de contact 26 du côté substrat.

Les galettes de soudure 28 sont réalisées en un matériau à bas point de fusion tel que l'indium. Ce matériau est apte à mouiller, à l'état fondu, le métal 26 restant et à ne pas mouiller l'isolant 14 mis à nu lors de la gravure des galettes et des zones de contact. En particulier, les zones de contact 26 sont en or.

L'étape suivante du procédé consiste à déposer sur l'ensemble de la structure une couche 30 de protection notamment en silice de 0,5 à 2µm d'épaisseur que l'on grave à l'aide du masque M4 pour qu'elle comporte une ouverture en regard du guide 8 fixant les dimensions de l'évidement 15 du substrat.

On effectue alors une gravure de type isotrope du substrat afin de dégager la languette 17 destinée à supporter à son extrémité la lentille 10, cette gravure est par exemple une gravure micro-onde (fréquence typique de 45GHz) utilisant les gaz réactifs Ar,SF₆ et O₂. Elle est réalisée sur une profondeur supérieure à la largeur du guide.

On effectue alors l'élimination de la couche de protection 30 de silice.

La lentille 10 est obtenue en faisant fondre l'extrémité de la languette 17 à l'aide d'une illumination laser de l'extrémité de la languette 17 à une longueur d'onde absorbée par la silice telle que l'émission à 10,6 µm d'un laser à CO₂ ou celle d'un laser à courte longueur d'onde (<230nm). Cette illumination est faite par dessus soit normalement au plan du substrat, soit avec une inclinaison par rapport à son plan.

La structure finale après réalisation de l'évidement 15 dans le substrat et de la lentille d'extrémité 10 est représentée en perspective sur la figure 8.

Au cas où la température engendrée par l'illumination laser pourrait affecter les galettes de soudure 28 et les zones de mouillage 26, il est possible de réaliser la lentille d'extrémité 10 avant le dépôt de ces couches métalliques.

Lorsque les couches de métal sont déposées avant la fabrication de la lentille, le dépôt de la couche 30 de protection doit être effectué à basse température afin d'éviter la fusion du métal 28.

En outre, il est possible d'intercaler entre les couches métalliques 26 et 28 et la couche de protection 30 une couche de résine photosensible qui facilitera le retrait de cette couche de protection en fin de réalisation de la lentille.

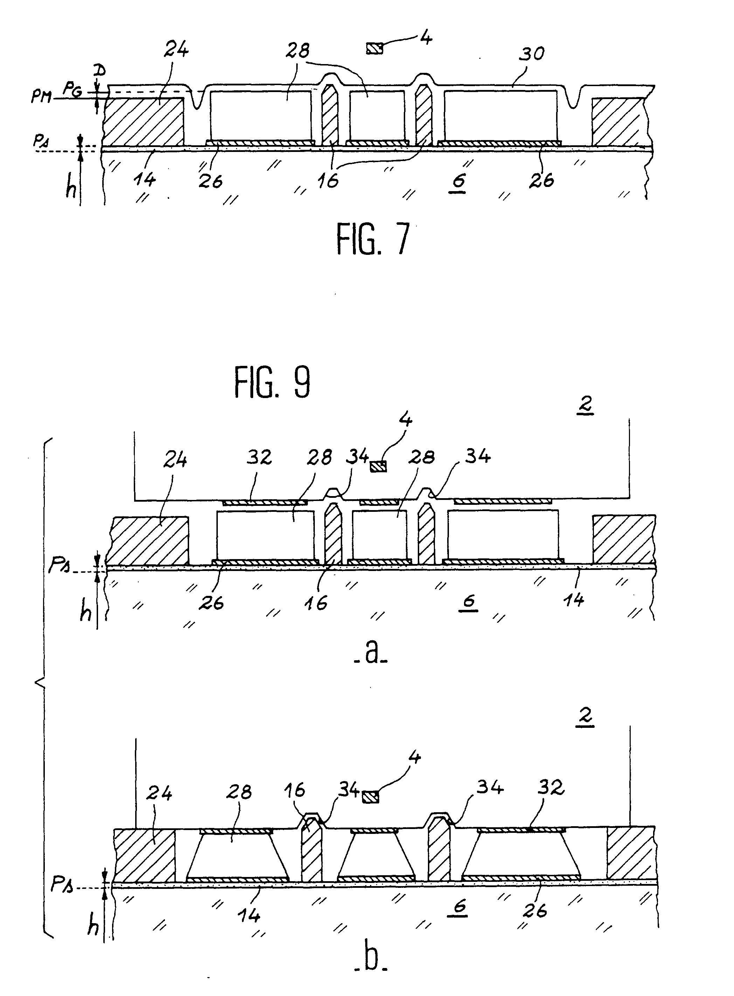

Les étapes suivantes du procédé concernent l'hybridation de la diode comme représenté sur la figure 9. En vue de cette hybridation, la diode 2 comporte des plots métalliques 32 sur sa face inférieure destinée à être soudée via les galettes de soudure 28. Ces plots 32 sont réalisés en un métal apte à être mouillé par le matériau de soudure et notamment en or.

Bien entendu le nombre de plots 32 de la diode correspond notamment au nombre de plots métalliques 26 équipés chacun d'une galette de soudure 28.

Afin d'assurer un positionnement latéral correct de la diode grâce aux butées 16, celle-ci doit comporter des encoches 34 destinées à venir s'emboîter sur des butées 16. La partie a de la figure 9 représente le positionnement de la diode avant soudure et la partie b le positionnement de la diode après soudure.

En bonne logique, la réalisation des encoches 34 doit être conduite de manière identique à celle des plots 16, c'est-à-dire grâce à un procédé d'"auto-alignement" avec la zone guidante du composant à hybrider, en l'occurrence la zone émissive 4 dans le cas d'une diode laser.

Au moment de la soudure les plots 32 et 26, du fait des tensions superficielles, s'auto-positionnent automatiquement assurant l'emboîtement de la partie supérieure 16a des butées 16 dans les encoches 34 et l'alignement parfait de la zone émissive 4 et du coeur guide 20, du fait de leur auto-positionnement respectif par rapport aux encoches et aux butées.

Après fusion, les galettes de soudure s'écrasent et prennent la forme représentée sur la partie b de la figure 9 de sorte que la surface inférieure de la diode 2 vient prendre appui sur les cales d'épaisseur 24.

Afin d'assurer une grande surface d'échange thermique du côté du substrat 6, qui joue le rôle de radiateur lors du fonctionnement de la diode, il est intéressant de réaliser les plots 26 métalliques de sorte que leurs surfaces soient supérieures à celles des plots 32.

Les surfaces des plots 26 et 32 sont déterminées de sorte que lors de la fusion des galettes de soudure 28 le plan de surface PG des galettes puisse s'abaisser et prendre une position située au-dessous du plan PM. C'est ce qui se passerait si les cales 24 n'existaient pas.

La position finale verticale de la diode est atteinte dès que sa surface inférieure repose sur les cales 24.

L'invention repose ici sur le fait que l'effet des forces de tension superficielle peut jouer son rôle juste avant que la diode 2 ne vienne reposer sur les cales 24. Une fois cette position atteinte, les forces de frottement mises en jeu ne permettent plus la mise à profit, de façon aussi aisée, des forces de tension superficielle. Ceci explique le fait que le plan PG doit être au-dessus du plan PM.

Dans le cas contraire, la diode reposerait, avant soudure sur les cales 24 et les forces de frottement empêcheraient la mise à profit des forces de tension superficielle pour l'alignement latéral de la diode 2 et l'emboîtement automatique des plots 16 dans les encoches 34.

## Revendications

1. Procédé d'hybridation et de positionnement latéral et vertical, sur un substrat (6), d'un composant optoélectronique (2) intégré à guidage confiné de la lumière par rapport à une extrémité (10) d'un guide optique (8) formé sur ce substrat et comportant un coeur guidant (20), le composant comportant au moins un plot (32) en un premier matériau sur une face à hybrider, ce procédé consistant à :
- former sur le substrat au moins une butée (16) dont la partie supérieure (16a) détermine le positionnement latéral de ce composant, par emboîtement dans au moins une encoche (34) spéciale, formée sur la face du composant à hybrider de façon à être autoalignée avec une zone active (4) du composant,
- former des cales d'épaisseur (24) sur le substrat (6), destinées à supporter le composant (2) lorsque qu'il est soudé au substrat, ayant une hauteur fixant le positionnement vertical du composant, la butée (16) étant intercalée entre les cales d'épaisseur (24),
- former au moins un plot (26) d'un second matériau sur le substrat (6), décalé par rapport à la cale d'épaisseur,
- former sur le plot (26) de second ou de premier matériau une galette (28) de soudure en un matériau fusible, apte à mouiller à l'état fondu les premier et second matériaux et pas leur environnement,
- positionner le composant (2) de façon que la butée (16) s'emboîte dans l'encoche (34) et que la galette (28) de soudure soit en regard du plot non pourvu de galette,
- porter l'ensemble à une température assurant la fusion de la galette, et
- ramener l'ensemble à une température inférieure à la température de fusion du matériau de la galette (28);
les cales d'épaisseur (24) présentant une hauteur inférieure à une épaisseur séparant le composant du substrat avant la fusion de la galette.

2. Procédé selon la revendication 1, **caractérisé en ce que** le guide comporte un coeur guidant (20) intercalé entre une couche inférieure et une couche supérieure de matériaux d'indice de réfraction inférieur à celui du coeur et **en ce que** les butées (16) sont définies par la gravure d'au moins la couche supérieure du guide (22), de part et d'autre du coeur du guide (20).

3. Procédé selon la revendication 2, **caractérisé en ce que** les butées (16) sont réalisées en même temps que le guide optique (8) et en utilisant le même masque (M1) fixant les dimensions des parties supérieures des butées et celles du coeur du guide.

4. Procédé selon l'une quelconque des revendications 1 à 3, **caractérisé en ce qu'**on réalise une lentille de focalisation (10) à l'extrémité du guide (8).

5. Procédé selon l'une quelconque des revendications précédentes, **caractérisé en ce que** le plot (26) de second matériau a une surface supérieure à celle de la galette (28) et à celle du plot (32) de premier matériau.

6. Procédé selon l'une quelconque des revendications 1 à 5, **caractérisé en ce que** la galette (28) présente la forme d'une bande dont la longueur est adaptée à celle du composant.

7. Procédé selon l'une quelconque des revendications précédentes, **caractérisé en ce que** le second matériau est métallique.

8. Procédé selon la revendication 7, **caractérisé en ce qu'**on interpose entre le substrat (6) et le plot (26) de second matériau un isolant électrique (14).

9. Procédé selon la revendication 9, **caractérisé en ce que** les couches supérieure (22), inférieure (18) et le coeur (20) sont en silice dopé ou non de façon que l'indice de réfraction du coeur soit supérieur à celui des couches supérieure et inférieure.

10. Procédé selon la revendication 9, **caractérisé en ce que** les couches supérieure et inférieure sont en silice dopé ou non et le coeur est en SiOₓN_{y} avec 0≤x≤2, 0≤y≤4/3 et 0<x+y≤2, en Al₂O₃ ou en Si₃N₄.

11. Procédé selon l'une quelconque des revendications précédentes, **caractérisé en ce que** l'on forme plusieurs cales d'épaisseur (24) réparties sur le substrat (6) de façon à supporter le composant (2) par sa périphérie.

## Patentansprüche

1. Verfahren zur Hybridisierung und lateralen und vertikalen Positionierung eines auf einem Substrat (6) integrierten optoelektronischen Bauteils (2) mit geschlossener Leitung des Lichts in Bezug auf ein Ende (10) eines optischen Leiters (8), ausgebildet auf diesem Substrat und einen leitenden Kern (20) umfassend, wobei das Bauteil auf einer Hybridisierungsfläche wenigstens ein Kontaktelement (32) aus einem ersten Material umfasst und dieses Verfahren dabei darin besteht:
- auf dem Substrat wenigstens einen Anschlag (16) auszubilden, dessen Oberteil (16a) die laterale Positionierung dieses Bauteils bestimmt, durch Einfügung in wenigstens eine in der Fläche des zu hybridisierenden Bauteils ausgebildete spezielle Kerbe (34), so dass es sich von selbst auf eine aktive Zone (4) des Bauteils ausrichtet,
- auf dem Substrat (6) Dickenelemente (24) auszubilden, die dazu dienen, das Bauteil (2) zu stützen, wenn es auf das Substrat gelötet wird, und deren Höhe die vertikale Positionierung des Bauteils festlegt, wobei der Anschlag (16) zwischen den Dickenelementen (24) angeordnet ist,
- auf dem Substrat (6) wenigstens ein Kontaktelement (26) aus einem zweiten Material auszubilden, versetzt in Bezug auf das Dickenelement,
- auf dem Kontaktelement (26) aus dem zweiten oder dem ersten Material ein Lötungselement (28) aus einem schmelzbaren Material auszubilden, fähig im geschmolzenen Zustand das erste und zweite Material aber nicht ihre Umgebung zu netzen,
- das Bauteil (2) so zu positionieren, dass der Anschlag (16) sich in die Kerbe (34) setzt und dass das Lötungselement (28) dem nicht mit einem Lötungselement versehenen Kontaktelement gegenübersteht,
- das Ganze auf eine Temperatur zu bringen, die das Schmelzen des Lötungselements bewirkt, und
- das Ganze auf eine Temperatur zurückzubringen, die niedriger ist als die Schmelztemperatur des Materials des Lötungselements (28);
wobei die Höhe der Dickenelemente (24) kleiner ist als eine vor dem Schmelzen des Lötungselements das Bauteil von dem Substrat trennende Dicke.

2. Verfahren nach Anspruch 1,
**dadurch gekennzeichnet,**
**dass** der Leiter einen leitenden Kern (20) umfasst, eingefügt zwischen einer unteren Schicht und einer oberen Schicht aus Materialien mit einer niedrigeren Brechzahl als der des Kems, und **dadurch**, dass die Anschläge (16) durch das Ätzen von wenigstens der oberen Schicht des Leiters (22) beiderseits des Leiterkems (20) definiert werden.

3. Verfahren nach Anspruch 2, **dadurch gekennzeichnet, dass** die Anschläge (16) gleichzeitig mit dem optischen Leiter (8) realisiert werden, und indem man dieselbe Maske (M1) benutzt, welche die Dimensionen der Oberteile der Anschläge und die des Leiterkems festlegt.

4. Verfahren nach einem der Ansprüche 1 bis 3, **dadurch gekennzeichnet, dass** man am Ende des Leiters (8) eine Fokussierlinse (10) realisiert.

5. Verfahren nach einem der vorangehenden Ansprüche, **dadurch gekennzeichnet, dass** das Kontaktelement (26) aus dem zweiten Material eine Oberfläche hat die größer ist als diejenige des Lötungselements (28) und diejenige des Kontaktelements (32) aus dem ersten Material.

6. Verfahren nach einem der Ansprüche 1 bis 5, **dadurch gekennzeichnet, dass** das Lötungselement (28) die Form eines Streifens hat, dessen Länge an die des Bauteils angepasst ist.

7. Verfahren nach einem der vorangehenden Ansprüche, **dadurch gekennzeichnet, dass** das zweite Material metallisch ist.

8. Verfahren nach Anspruch 7, **dadurch gekennzeichnet, dass** man zwischen dem Substrat (6) und dem Kontaktelement (26) aus dem zweiten Material einen elektrischen Isolator (14) einfügt.

9. Verfahren nach einem der vorangehenden Ansprüche, **dadurch gekennzeichnet, dass** die obere Schicht (22), die untere Schicht (18) und der Kern (20) aus dotiertem oder nicht-dotiertem Siliciumdioxid sind, so dass die Brechzahl des Kems höher ist als die der unteren und der oberen Schicht.

10. Verfahren nach Anspruch 9, **dadurch gekennzeichnet, dass** die obere und die untere Schicht aus dotiertem oder nicht-dotiertem Siliciumdioxid sind und der Kern aus SiOₓN_{y} mit O≤x≤2 0≤y≤4/3 und 0<x+y≤2, aus Al₂O₃ oder aus Si₃N₄ ist.

11. Verfahren nach einem der vorangehenden Ansprüche, **dadurch gekennzeichnet, dass** man mehrere so auf dem Substrat (6) verteilte Dickenelemente (24) ausbildet, dass das Bauteil (2) durch seine Peripherie abgestützt wird.

## Claims

1. Process for the hybridization and lateral and vertical positioning on a substrate (6) of an integrated optoelectronic component (2) having confined light guidance with respect to one end (10) of an optical guide (8) formed on said substrate and having a guiding core (20), the component having at least one stud or pad (32) of a first material on a face to be hybridized, said process comprising:
- forming on the substrate at least one abutment (16), whose upper part (16a) determines the lateral positioning of said component by fitting in at least one special notch (34), formed on the face of the component to be hybridized so as to be self-aligned with an active zone (4) of the component,
- forming shims (24) on the substrate (6) for supporting the component (2) when welded thereto having a height fixing the vertical positioning of the component, the abutment (16) being inserted between the shims (24),
- forming at least one stud or pad (26) or a second material on the substrate (6) and which is displaced with respect to the shim,
- forming on the pad (26) of the second or first material a welding chip (28) made from a meltable material able to wet in the molten state the first and second materials and not the area around them,
- positioning the component (2) in such a way that the abutment (16) is fitted into the notch (34) and the welding chip (28) faces the pad not provided with a chip,
- heating the assembly to a temperature ensuring the melting of the chip and
- bringing the assembly to a temperature below the melting point of the material of the chip (28), the shims (24) having a height less than the thickness separating the component from the substrate prior to the melting of the chip.

2. Process according to claim 1, **characterized in that** the guide incorporates a guiding core (20) placed between a lower layer and an upper layer of materials having a refractive index lower than that of the core and **in that** the abutments (16) are defined by the etching of at least one upper layer of the guide (22) on either side of the core of the guide (20).

3. Process according to claim 2, **characterized in that** the abutments (16) are produced at the same time as the optical guide (8) and by using the same mask (M1) fixing the dimensions of the upper portions of the abutments and those of the guide core.

4. Process according to any one of the claims 1 to 3, **characterized in that** a focussing lens (10) is produced at the end of the guide (8).

5. Process according to any one of the preceding claims, **characterized in that** the second material pad (26) has a surface larger than that of the chip (28) and that of the first material pad (32).

6. Process according to any one of the claims 1 to 5, **characterized in that** the chip (28) is shaped like a band, whose length is matched to that of the component.

7. Process according to any one of the preceding claims, **characterized in that** the second material is metallic.

8. Process according to claim 7, **characterized in that** an electrical insulant (14) is placed between the substrate (6) and the second material pad (26) .

9. Process according to claim 9 (sic), **characterized in that** the upper layer (22), lower layer (18) and core (20) are of silica, which may or may not be doped, in such a way that the refractive index of the core is higher than that of the upper and lower layers.

10. Process according to claim 9, **characterized in that** the upper or lower layers are of doped or undoped silica and the core is of SiOₓN_{y} with 0 ≤ x < 2, O ≤ y ≤ 4/3 and 0 < x+y ≤ 2, of Al₂O₃ or Si₃N₄.

11. Process according to any one of the preceding claims, **characterized in that** formation takes place of several shims (24) distributed over the substrate (6), so as to support the periphery of the component (2).
